# EUROPÄISCHE PATENTSCHRIFT

(11) **EP 0 677 857 B1**
(45) Veröffentlichungstag und Bekanntmachung des Hinweises auf die Patenterteilung: **05.11.1997**
(21) Anmeldenummer: 95103825.6
(22) Anmeldetag: 16.03.1995
(51) Int. Cl.: H01H 9/02, H03K 17/945

(54) **Elektrischer Schalter mit Tastkopf**
Electric switch with probe
Commutateur électrique à palpeur

(30) Priorität: 15.04.1994 DE 4412923
(43) Veröffentlichungstag der Anmeldung: 18.10.1995
(73) Patentinhaber: Bernstein Senso-Plus GmbH, D-31675 Bückeburg (DE); Pulsotronic Merten GmbH & Co. KG, 51674 Wiehl-Bomig (DE)
(72) Erfinder: Chwieralski, Alfred, Dr.-Ing. Dipl.-Ing., D-51107 Köln (DE); Wecke, Rolf, Dipl.-Ing., D-32457 Porta Westfalica (DE)
(74) Vertreter: Stracke, Alexander, Dipl.-Ing.

(56) Entgegenhaltungen:
- EP-A- 0 132 661
- DE-A- 2 819 782
- DE-A- 3 324 242
- DE-U- 8 310 483
- FR-A- 2 608 755
- US-A- 4 785 240

## Beschreibung

Die Erfindung betrifft einen elektrischen Schalter mit Tastkopf, mit einem Schaltergehäuse, das aus einem Unterteil und einem lösbar damit verbundenen Oberteil besteht, wobei in dem Oberteil ein Befestigungsteil des Tastkopfes mittels einer Halterung drehbar festsetzbar ist. Die Bezeichnung "elektrischer Schalter" ist dabei umfassend in dem Sinne zu verstehen, daß zur Aufnahme, Auswertung und Weitergabe der vom Tastkopf registrierten Steuerimpulse auch elektronische, optoelektrische und dergleichen Bauelemente eingesetzt werden können. Der Tastkopf selbst kann induktiv, kapazitiv, optisch, mit Ultraschall oder auch mechanisch arbeiten.

Aus dem DE-GM 83 10 483 ist ein Schalter der gattungsgemäßen Art in Form eines berührungslos wirkenden elektronischen Schalters bekannt, bei dem das Oberteil und das Unterteil des Gehäuses einerseits durch eine Einstecklasche und einen Halter und andererseits durch Schrauben miteinander verbunden werden. Die Montage ist insoweit relativ umständlich. Das dortige Befestigungsteil des Tastkopfes wird im Oberteil des Gehäuses mittels einer Halterung festgesetzt, die aus einer einstückig haarnadelförmigen Feder besteht, die in eine Umfangsnut eines Lagerzapfens dieses Befestigungsteiles eingreift. Für diesen haarnadelförmigen Riegel sind im Oberteil gesonderte Widerlager vorgesehen. Die Montage ist auch insoweit umständlich. Für den Tastkopf ist dort ferner ein Rastgesperre vorgesehen, so daß dem Tastkopf vorbestimmte unterschiedliche Drehstellungen gegeben werden können. Der Tastkopf ist ferner dort bereits geteilt und hat neben dem Befestigungsteil ein Sensorteil, das in unterschiedlichen Stellungen an dem Befestigungsteil angeordnet werden kann.

Der vorliegenden Erfindung liegt die Aufgabe zugrunde, einen Schalter der gattungsgemäßen Art zu schaffen, der bei sicherem Zusammenhalt aller Bauteile denkbar einfach zu montieren und demontieren ist.

Die erfindungsgemäße Lösung ergibt sich aus den Merkmalen des Patentanspruches 1. Das Oberteil und Unterteil werden ausschließlich durch Rastelemente miteinander verbunden, so daß insbesondere durch den Fortfall von Verschraubungen Montage und Demontage vereinfacht sind. Der auf dem Oberteil verrastete Deckel hat dabei eine mehrfache Blockierfunktion, indem er in seiner Schließstellung mindestens ein Rastelementenpaar der Rastverbindung zwischen Oberteil und Unterteil des Gehäuses in der eingerasteten Stellung blockiert und indem er ferner in seiner Schließstellung auch die Halterung für das Lagerteil des Tastkopfes in der Fixierstellung blockiert. Die wesentlichen Bauelemente werden somit in ihren Fixier- und Schließstellungen sehr zuverlässig in verriegelter Stellung gehalten, egal in welcher Raumlage später ein derartiger Schalter auf einer festen Unterlage montiert wird.

In weiterer sehr zweckmäßiger Ausgestaltung befindet sich an der Halterung für das Lagerteil des Tastkopfes im Gehäuseoberteil noch mindestens ein Widerlager, das in der Fixierstellung der Halterung ein Rastelementenpaar der Rastverbindung zwischen Oberteil und Unterteil des Gehäuses in deren Raststellung blockiert. Damit wird eine weitere Rastverbindungsstelle zwischen Gehäuseoberteil und -unterteil gesichert. Gemäß einer weiteren besonders zweckmäßigen Ausgestaltung befindet sich an dem Befestigungsteil des Tastkopfes auf einem Teilkreis auf der dem Schaltergehäuse zugewandten Seite ein Zahngesperre und an dem Deckel befinden sich an seinem entsprechenden Ende Sperrstücke, die in der Schließstellung des Deckels in Lücken des Zahngesperres eingreifen. Auch dies trägt zu einer außerordentlich einfachen Handhabung bei. Lediglich durch Überführen des Deckels in die Offenstellung kann der Tastkopf bei Umstellungsarbeiten in die gewünschte Drehlage verdreht werden, in der er dann lediglich durch Schließen des Deckels fixiert wird.

Gemäß einer weiteren bevorzugten Ausgestaltung ist bei einem gattungsgemäßen Schalter mit einem geteilten Tastkopf und einem Bügel zur Fixierung der Tastkopfteile in ihrer Verbindungsstellung eine Anordnung vorgesehen, nach der in einer vorgegebenen Drehlage des Tastkopfes der Bügel dem Deckel gegenüberliegt und der Deckel in seiner Schließlage den Bügel blockiert und ihn in einer Offenstellung freigibt. Dem Deckel ist somit eine weitere Funktion zugeordnet, nämlich die Möglichkeit der Freigabe des verriegelnden Bügels des Tastkopfes und damit der Möglichkeit von Umsteckarbeiten am Tastkopf. Bei geschlossenem Deckel kann der Bügel des Tatkopfes nicht abgenommen werden. Wo in der Schließstellung des Deckels der Bügel des Tastkopfes nicht durch den Deckel blockiert ist, wird er in entsprechenden Tastkopfdrehstellungen durch das Schaltergehäuse direkt blockiert.

Ein Ausführungsbeispiel eines Schalters gemäß der Erfindung wird nachstehend unter Bezugnahme auf die Zeichnung näher beschrieben. Es zeigen:
- Figur 1:: eine vereinfachte sprengbildliche Darstellung eines Schalters gemäß der Erfindung,

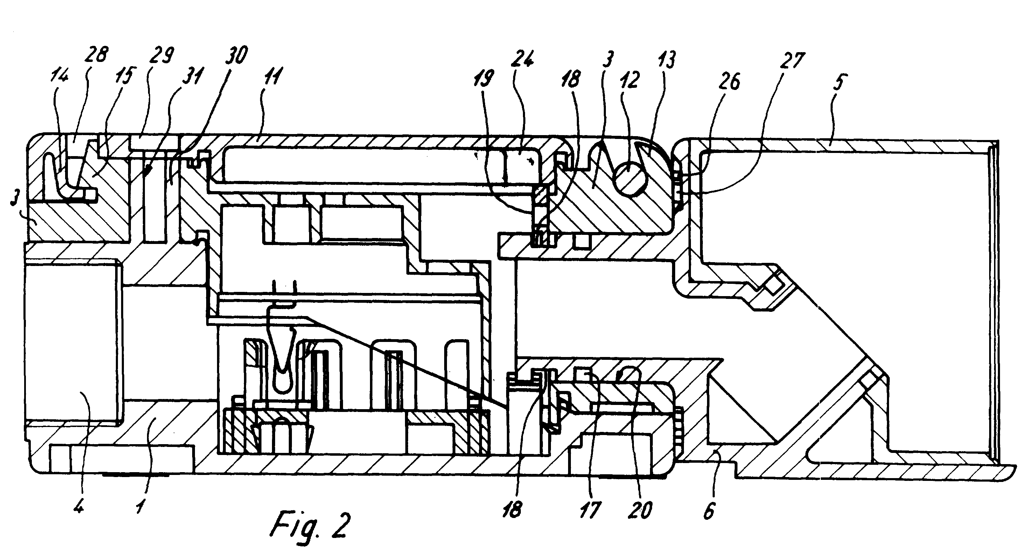

- Figur 2:: einen Längsschnitt durch einen fertig montierten Schalter gemäß der Erfindung,
- Figur 3: einen Querschnitt durch den Schalter mit Darstellung der Halterung für das Lagerteil des Tastkopfes des Schalters.

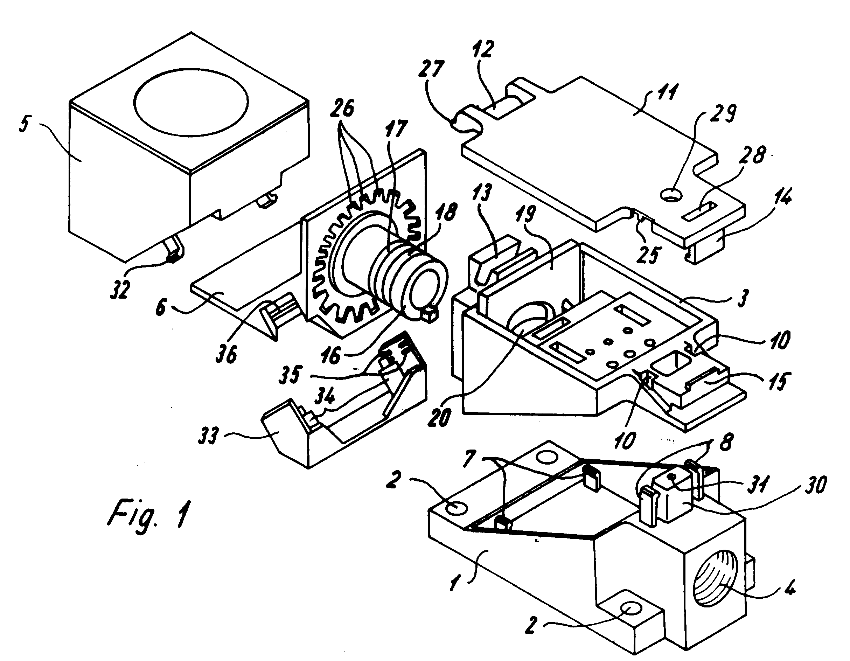

Die Figur 1 zeigt in sprengbildlicher Darstellung die wesentlichen Elemente des Schaltergehäuses und den Tastkopf eines berührungslos arbeitenden Schalters, wobei die Elektrik bzw. Elektronik im Inneren des Schaltergehäuses, da für die vorliegende Erfindung nicht relevant, nicht gezeigt und beschrieben wird. Es handelt sich insoweit um bekannte elektrisch/elektronische Bauteile.

Das Schaltergehäuse hat ein Unterteil 1, in dessen Bodenplatte Bohrungen 2 vorgesehen sind, um den Schalter in seiner Gesamtheit auf einer festen Unterlage oder dergleichen festschrauben zu können. Das Schaltergehäuse beinhaltet ferner ein Oberteil 3. Die Teilung zwischen Unterteil 1 und Oberteil 3 verläuft diagonal. Das Unterteil 1 hat eine Zuführungsöffnung 4 zum Einführen eines elektrischen Kabels. Die elektrischen Anschlußelemente befinden sich im Unterteil 1. Das Oberteil 3 beinhaltet aus elektrischer Sicht im wesentlichen eine mit elektronischen Bauelementen bestückte Leiterplatte, Steckverbindungen zu den Anschlußteilen im Unterteil 1 sowie die elektrische Verbindung zu einem Sensorteil 5 eines ebenfalls diagonal geteilten, aus dem Sensorteil 5 und einem Befestigungsteil 6 bestehenden Tastkopfes.

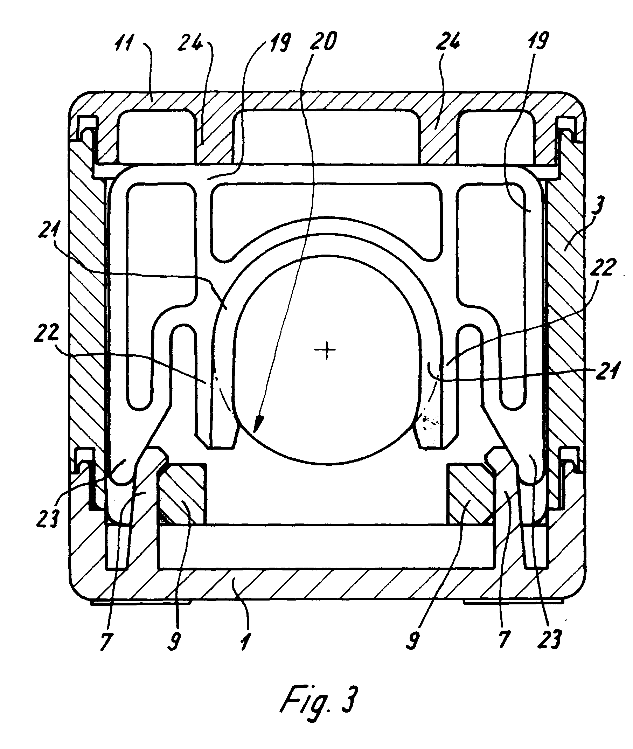

Das Unterteil 1 und das Oberteil 3 sind lösbar ausschließlich durch Rastelemente zu verbinden, wozu im dargestellten Ausführungsbeispiel, bezogen auf die diagonale Teilungsebene, am Unterteil 1 in der unteren Ebene zwei Rasthaken 7 und in der oberen Ebene des Unterteiles zwei Rasthaken 8 vorgesehen sind. Für die Rasthaken 7 des Unterteiles 1 sind im Oberteil 3 Widerlagerstücke 9 (siehe Figur 3) vorgesehen, die in der Schnappstellung von den Rasthaken 7 übergriffen werden können. Für die Rasthaken 8 des Unterteiles 1 sind im Oberteil Aufnahmen 10 vorgesehen, an deren Innenwänden kleine Rastwulste (nicht dargestellt) vorgesehen sind, die von den hakenförmigen Enden der Rasthaken 8 übergriffen werden können.

Auf dem Oberteil 3 ist nun benachbart des den Tastkopf 5, 6 aufnehmenden Endes ein Deckel 11 mittels einer Achse 12 drehbar in einem Lagerstück 13, in das die Achse 12 schnappend rastend eingesetzt werden kann, gelagert. An seinem freien Ende trägt der Deckel 11 einen Rasthaken 14, für den an entsprechender Stelle auf dem Oberteil 3 ein Widerlagerstück 15 vorgesehen ist, in das der Rasthaken 14 in der Schließstellung schnappend rastend eingreifen kann.

An dem Befestigungsteil 6 des Tastkopfes befindet sich ein vorspringender Lagerzapfen 16, der eine umlaufende Nut 17 zur Aufnahme einer Dichtung sowie ferner eine umlaufende Nut 18 aufweist, mit deren Hilfe er in dem Oberteil 3 mittels einer Halterung drehbar zu fixieren ist. Im dargestellten Ausführungsbeispiel besteht diese Halterung aus einem bügelförmigen Riegel 19, der längs der entsprechenden Begrenzungswand des Oberteiles 3 nach Einstecken des Lagerzapfens 16 in die entsprechende Aufnahmebohrung 20 des Oberteiles 3 von oben eingesetzt werden kann, derart, daß zwei an dem Riegel 19 vorgesehene, mit schmalen Haltestegen 21 versehene Bügel 22 den Lagerzapfen 16 übergreifen und dabei die Haltestege 21 in die umlaufende Nut 18 des Lagerzapfens 16 eingreifen (Figur 3). Danach kann der Lagerzapfen 16 nicht mehr zurückgezogen werden.

Der Riegel 19 trägt ferner außenseitig zu den beiden Bügeln 22 noch Blockierstege 23. In der niedergedrückten Stellung des Riegels 19 übergreifen diese Blockierstege 23 von oben die Rasthaken 7 des Unterteiles in ihrer Verrastungslage mit den Widerlagerstücken 9 des Oberteiles 3, so daß diese Rastelemente 7, 9 in ihrer Raststellung blockiert sind.

An dem Deckel 11 befinden sich nun an entsprechender Stelle im dargestellten Ausführungsbeispiel zwei Nocken 24 (Figur 3), die in der verrasteten Schließstellung des Deckels 11 oben auf den bügelförmigen Riegel 19 drücken und ihn damit in seiner Fixierstellung niedergedrückt halten. Durch Schließung des Deckels ist damit die Halterung des Lagerzapfens 16 im Oberteil 3 in der Schließstellung blockiert. Gleichzeitig ist die Rastverbindung der Rastelemente 7, 9 blockiert.

In vergleichbarer Weise befinden sich an dem Deckel 11 zwei prismenförmige Nocken 25, und zwar an einer Stelle, daß sie in der verrasteten Schließlage des Deckels 11 auf die Rasthaken 8 des Unterteiles 1 einwirken können, wenn diese nach Zusammensetzen von Unterteil und Oberteil in den Aufnahmen 10 des Oberteiles verrastet sind. Auch diese Rastverbindung zwischen Unterteil 1 und Oberteil 3 ist damit in der Schließstellung des Deckels 11 blockiert.

Es ergibt sich somit eine insgesamt schraubenlose sehr zuverlässige Montage der wesentlichen Bauteile des Schaltergehäuses und des Tastkopfes.

Es besteht bei derartigen Schaltern vielfach das Erfordernis, den Tastkopf 5, 6 zur Anpassung an die unterschiedlichen Anwendungsfälle und bei Umstellungsarbeiten in unterschiedliche Raumlagen drehen zu können und in dieser Drehlage auch zu fixieren. Hierzu ist an dem Befestigungsteil 6 des Tastkopfes auf der dem Schaltergehäuse 1, 3 zugewandten Seitenwand ein Zahngesperre 26 ausgebildet, das sich auf einem Teilkreis befindet, im dargestellten Ausführungsbeispiel mit einer Zahnteillung von 15°. Es ist nun ferner an dem entsprechenden Ende des Deckels 11 rückwärtig an dessen beiden Lagerarmen jeweils ein Sperrstück 27 vorgesehen. In der Schließlage des Deckels 11 greifen diese Sperrstücke 27 in entsprechende Lücken des Zahngesperes 26 ein und fixieren damit den Tastkopf 5, 6 in der eingestellten Drehlage. Durch einfaches Öffnen des Deckels 11 können die Sperrstücke 27 aus dem Zahngesperre 26 herausgeschwenkt werden, so daß der Tastkopf 5, 6 dann in die gewünschte Drehlage verdreht werden kann.

Um den Deckel 11 im Bedarfsfall relativ einfach öffnen zu können, befindet sich in ihm eine Werkzeugzuführungsöffnung 28, durch die hindurch der Rasthaken 14 zugänglich ist, so daß er beispielsweise mittels eines Schraubendrehers aus seiner Raststellung gedrückt werden kann.

In manchen Anwendungsfällen für derartige Schalter besteht das Erfordernis einer zusätzlichen, Schließung. Für diese Anwendungsfälle befindet sich im dargestellten Ausführungsbeispiel im Deckel 11 ferner eine Durchgangsbohrung 29 und es befindet sich in der oberen Ebene des Unterteiles 1 zwischen den beiden Rasthaken 8 ein Ansatz 30, in dem sich eine Bohrung 31 befindet. Hier kann zur entsprechenden Festlegung des Deckels 11 in seiner Schließlage am Oberteil 3 eine selbstschneidende Schraube eingeschraubt werden.

Der Sensorteil 5 des Tastkopfes kann an dem Befestigungsteil 6 in mehreren Raumlagen angesetzt werden. Zur gegenseitigen Verbindung ist auch hier eine Rastverbindung vorgesehen. In Figur 1 sind insoweit die entsprechenden Rasthaken 32 am Sensorteil 5 zu sehen, für die sich am Befestigungsteil entsprechende Widerlager befinden. Auch die Rastverbindung zwischen dem Sensorteil 5 und dem Befestigungsteil 6 ist blockierbar, wozu ein Bügel 33 vorgesehen ist, an dem sich Blockierstege 34 befinden, die die Rastverbindung zwischen dem Sensorteil 5 und dem Befestigungsteil 6 in der Raststellung, bei eingestecktem Bügel 33, blockieren. Im Ausführungsbeispiel ist der Bügel 33 so angeordnet, daß er in diagonaler Schieberichtung auf eine Ecke des Befestigungsteiles 6 gesetzt werden kann. Der Bügel 33 trägt an seinen Armen innenseitig kleine Raststege 35, die mit Gegenrasten 36 im Grund der Bügelaufnahme 37 des Befestigungsteiles 6 zusammenwirken können.

In einer vorgegebenen Drehlage des Tastkopfes 5, 6, in der der Bügel 33 in seiner Längserstreckung dem hinteren Ende des Deckels 11 gegenüberliegt, blockieren die hinteren Enden der Lagerarme des Deckels 11 den Bügel 33 in seiner Schließlage. Wird in dieser vorgegebenen Drehlage nun der Deckel 11 geöffnet und dabei in eine halboffene Stellung gebracht, etwa dergestalt, daß er in einer Ebene mit der Diagonalebene liegt, in der der Bügel 33 verlagerbar ist, ist der Bügel 33 durch den Deckel 11 freigegeben. In dieser einen gegenseitigen Lage kann der Bügel 33 abgenommen werden und es kann das Umsetzen des Sensorteiles 5 relativ zum Befestigungsteil 6 durchgeführt werden. Nach Wiederaufsetzen des Bügels 33 und Schließen des Deckels 11 ist die Anordnung wieder blockiert. In allen anderen Drehlagen des Tastkopfes 5, 6 kann der Bügel 33 nicht abgenommen werden, sei es, daß er noch vom Deckel 11, überwiegend jedoch insbesondere von der unteren Ebene des Unterteiles 1 blockiert wird.

Der Deckel 11 besteht zweckmäßig aus durchsichtigem Material. Auf der Oberseite des Oberteiles 3 befindet sich das sogenannte Bedienerfeld mit Anzeigeelementen, Beschriftungen und dergleichen. Durch die Durchsichtigkeit des Deckelmateriales ist die volle Erkennbarkeit ohne das Erfordernis der Deckelöffnung gewährleistet.

Die vorstehend beschriebene Ausgestaltung hat den weiteren Vorteil, daß nur bei ordnungsgemäßer Verrastung von Oberteil und Unterteil und einwandfreier Einsteckung des Tastkopfes und Fixierung durch die Halterung der Deckel geschlossen werden kann. Der Schließvorgang des Deckels beinhaltet also automatisch auch die Kontrolle aller vorheriger Montagevorgänge.

## Patentansprüche

1. Elektrischer Schalter mit Tastkopf (5, 6), mit einem Schaltergehäuse (1, 3), das aus einem Unterteil (1) und einem lösbar damit verbundenen Oberteil (3) besteht, wobei in dem Oberteil (3) ein Befestigungsteil (6) des Tastkopfes (5, 6) mittels einer Halterung (19) drehbar festsetzbar ist, **dadurch gekennzeichnet**, daß das Oberteil (3) und das Unterteil (1) des Schaltergehäuses durch Rastelemente (7, 9; 8, 10) miteinander verbunden sind und auf dem Oberteil (3) ein Deckel (11) verrastbar ist, der in seiner Schließstellung mindestens ein Rastelementenpaar (8, 10) der Rastverbindung zwischen Ober- und Unterteil (1, 3) in der eingerasteten Stellung und ferner die Halterung (19) für das Befestigungsteil (6) des Tastkopfes (5, 6) in der Fixierstellung blockiert.

2. Schalter nach Anspruch 1, dadurch gekennzeichnet, daß der Deckel (11) an einem Ende schwenkbar auf dem Oberteil (3) gelagert ist und an seinem anderen, freien Ende ein Rastelement (14) trägt, für das auf dem Oberteil (3) ein Gegenrastelement (15) vorgesehen ist.

3. Schalter nach einem der vorhergehenden Ansprüche, dadurch gekennzeichnet, daß die Halterung für das Befestigungsteil (6) des Tastkopfes (5, 6) ein bügelförmiger Riegel (19) ist, der Stege (21) aufweist, die in eine Umfangsnut (18) eines in das Oberteil (3) einsteckbaren Lagerzapfens (16) des Befestigungsteiles (6) eingreifen und an dem Deckel (11) mindestens ein Nocken (24) vorgesehen ist, der in der Schließstellung des Deckels (11) den Riegel (19) in der Fixierstellung eingedrückt hält.

4. Schalter nach einem der vorhergehenden Ansprüche, dadurch gekennzeichnet, daß sich an der Halterung (19) mindestens ein Widerlager (23) befindet, das in der Fixierstellung der Halterung ein Rastelementenpaar (7, 9) der Rastverbindung zwischen dem Oberteil (3) und dem Unterteil (1) in deren Raststellung blockiert.

5. Schalter nach einem der vorhergehenden Ansprüche, dadurch gekennzeichnet, daß an dem Deckel (11) im Bereich seines verrastbaren Endes mindestens ein Nocken (25) vorgesehen ist, der in der Schließstellung des Deckels (11) ein Rastelementenpaar (8, 10) der Rastverbindung zwischen dem Oberteil (3) und dem Unterteil (1) in deren Raststellung blockiert.

6. Schalter nach einem der vorhergehenden Ansprüche, dadurch gekennzeichnet, daß an dem Befestigungsteil (6) des Tastkopfes (5, 6) an einer dem Schaltergehäuse (1, 3) zugewandten Seite auf einem Teilkreis ein Zahngesperre (26) vorgesehen ist und an dem Deckel (11) an dem entsprechenden Ende Sperrstücke (27) vorgesehen sind, die in der Schließstellung des Deckels (11) in Lücken des Zahngesperres (26) eingreifen.

7. Schalter nach einem der vorhergehenden Ansprüche, mit einem teilbaren Tastkopf (5, 6) und einem Bügel (33) zur Fixierung der Tastkopfteile (5, 6) in ihrer zusammengesteckten Stellung, dadurch gekennzeichnet, daß in einer vorgegebenen Drehlage des Tastkopfes (5, 6) der Bügel (33) dem Deckel (11) gegenüberliegend angeordnet ist, der Deckel (11) in seiner Schließlage in dieser Tastkopfdrehstellung den Bügel (33) blockiert und der Deckel in dieser Drehlage des Tastkopfes (5, 6) in einer Offenstellung den Bügel (33) freigibt.

8. Schalter nach Anspruch 7, dadurch gekennzeichnet, daß bei quaderförmigem Tastkopf (5, 6) der Bügel (33) in Diagonalrichtung auf eine Ecke des Tastkopfes (5, 6) aufsetzbar ist und der Deckel (11) im Bereich einer Neigungslage etwa entsprechend dieser Diagonalrichtung den Bügel (33) freigibt.

9. Schalter nach einem der vorhergehenden Ansprüche, dadurch gekennzeichnet, daß der Deckel (11) zumindest teilweise aus einem durchsichtigen Material besteht.

10. Schalter nach einem der vorhergehenden Ansprüche, dadurch gekennzeichnet, daß der Deckel (11) zusätzlich mittels einer Schraube (11) an dem Oberteil (3) des Schaltergehäuses festsetzbar ist.

11. Schalter nach einem der vorhergehenden Ansprüche, dadurch gekennzeichnet, daß in dem Deckel (11) eine zu seinem Rastelement (14) führende Werkzeugzuführungsöffnung (28) vorgesehen ist.

## Claims

1. An electrical switch with sensing head (5, 6), having a switch housing (1, 3) which comprises a lower portion (1) and an upper portion (3) releasably connected thereto, wherein a securing portion (6) of the sensing head (5, 6) can be rotatably fixed in the upper portion (3) by means of a holder (19) characterised in that the upper portion (3) and the lower portion (1) of the switch housing are connected together by retaining elements (7, 9; 8, 10) and a cover (11) can be latched on the upper portion (3), which cover in its closed position blocks at least one pair of retaining elements (8, 10) of the retaining connection between the upper and lower portions (1, 3) in the engaged position and also blocks the holder (19) for the securing portion (6) of the sensing head (5, 6) in the fixing position.

2. A switch according to claim 1 characterised in that the cover (11) is mounted at one end pivotably on the upper portion (3) and at its other free end carries a retaining element (14) for which a co-operating retaining element (15) is provided on the upper portion (3).

3. A switch according to one of the preceding claims characterised in that the holder for the securing portion (6) of the sensing head (5, 6) is a stirrup-shaped locking member (19) having legs (21) which engage into a peripheral groove (18) in a mounting trunnion (16), which can be fitted into the upper portion (3), of the securing portion (6), and provided on the cover (11) is at least one projection (24) which in the closed position of the cover (11) holds the locking member (19) in a pressed-in condition in the fixing position.

4. A switch according to one of the preceding claims characterised in that disposed on the holder (19) is at least one support portion (23) which in the fixing position of the holder blocks a pair of retaining elements (7, 9) of the retaining connection between the upper portion (3) and the lower portion (1 ) in the retaining position thereof.

5. A switch according to one of the preceding claims characterised in that provided on the cover (11) in the region of its latchable end is at least one projection (25) which in the closed position of the cover (11) blocks a pair of retaining elements (8, 10) of the retaining connection between the upper portion (3) and the lower portion (1) in the retaining position thereof.

6. A switch according to one of the preceding claims characterised in that a locking tooth arrangement (26) is provided on a pitch circle on the securing portion (6) of the sensing head (5, 6) at a side towards the switch housing (1, 3) and provided on the cover (11) at the corresponding end are locking portions (27) which in the closed position of the cover (11) engage into gaps between the teeth of the locking tooth arrangement (26).

7. A switch according to one of the preceding claims comprising a dividable sensing head (5, 6) and a stirrup (33) for fixing the sensing head portions (5, 6) in their assembled position characterised in that in a predetermined rotational position of the sensing head (5, 6) the stirrup (33)is arranged in opposite relationship to the cover (11), the cover (11) in its closed position blocks the stirrup (33) in said sensing head rotational position and the cover releases the stirrup (33) in said rotational position of the sensing head (5, 6) in an open position.

8. A switch according to claim 7 characterised in that with a cuboidal sensing head (5, 6) the stirrup (33) can be fitted in a diagonal direction on to a corner of the sensing head (5, 6) and the cover (11) releases the stirrup (33) in the region of an inclined position approximately corresponding to said diagonal direction.

9. A switch according to one of the preceding claims characterised in that the cover (11) at least partially comprises a transparent material.

10. A switch according to one of the preceding claims characterised in that the cover (11) can additionally be fixed by means of a screw (11) on the upper portion (3) of the switch housing.

11. A switch according to one of the preceding claims characterised in that provided in the cover (11) is a tool insertion opening (28) leading to its retaining element (14).

## Revendications

1. Interrupteur électrique muni d'un palpeur (5, 6) avec un boîtier (1, 3) se composant d'une partie inférieure (1) et d'une partie supérieure (3) amovible qui y est reliée, un élément de fixation (6) du palpeur (5, 6) pouvant être fixé de manière pivotante sur la partie supérieure (3) au moyen d'une attache (19), caractérisé en ce que la partie supérieure (3) et la partie inférieure (1) du boîtier sont reliées par des éléments à encoches (7, 9; 8, 10) et qu'un couvercle (11) peut être fixé par encoches sur la partie supérieure (3), ledit couvercle bloquant en position de fermeture, au moins une paire d'éléments à encoches (8, 10) de l'assemblage par encoches de la partie supérieure et de la partie inférieure (1, 3) en position encliquetée et, par ailleurs, bloquant l'attache (19) pour l'élément de fixation (6) du palpeur (5, 6) en position de fixation.

2. Interrupteur selon la revendication 1, caractérisé en ce que le couvercle (11) est monté de façon pivotante sur la partie supérieure (3) à l'une des ses extrémités et est muni, à l'autre de ses extrémités, d'un élement à encoche (14), pour lequel est prévu un élement à encoche correspondant (15) sur la partie supérieure (3).

3. Interrupteur selon l'une des revendications précédentes, caractérisé en ce que l'attache pour l'élément de fixation (6) du palpeur (5, 6) consiste en un verrou en étrier (19), présentant des traverses (21) qui sont engrenées dans une encoche circonférentielle (18) d'un tourillon (16) de l'élément de fixation (6) enfichable dans la partie supérieure (3) et en ce que, sur le couvercle (11), est prévu au moins un ergot (24) qui, en position de fermeture du couvercle (11), maintient le verrou (19) enfoncé en position de fixation.

4. Interrupteur selon les revendications précédentes, caractérisé en ce que sur l'attache (19) se trouve au moins une butée (23), qui, en position de fixation de l'attache, bloque un élement à encoches (7, 9) de l'assemblage par encoches de la partie supérieure (3) et de la partie inférieure (1) dans leur position encliquetée.

5. Interrupteur selon l'une des revendications précédentes, caractérisé en ce qu'il est prévu sur le couvercle (11) et dans la zone de son extrémité encliquetable au moins un ergot (25) qui, en position de fermeture du couvercle (11), bloque une paire d'éléments à encoches (8, 10) de l'assemblage par encoches de la partie supérieure (3) et de la partie inférieure (1) dans leur position encliquetée.

6. Interrupteur selon l'une des revendications précédentes, caractérisé en ce que sur un élément de fixation (6) du palpeur (5, 6) et sur un côté tourné vers le boîtier (1, 3) est prévu un encliquetage (26) sur un cercle primitif, ainsi que des arrêts (27) sur le côté correspondant du couvercle (11) qui, en position de fermeture du couvercle (11) s'engrènent dans les vides de l'encliquetage (26).

7. Interrupteur selon l'une des revendications précédentes avec un palpeur (5, 6) divisible et une traverse (33) pour la fixation des éléments du palpeur (5, 6) dans leur position assemblée, caractérisé en ce que la traverse (33) est disposée en face du couvercle (11) dans une position de pivotement préréglée du palpeur (5, 6), en ce que le couvercle (11), dans sa position de fermeture et dans cette position de pivotement du palpeur bloque la traverse (33) et que le couvercle dans cette position de pivotement du palpeur (5, 6) libère la traverse (33) en position d'ouverture.

8. Interrupteur selon la revendication 7, caractérisé en ce que la traverse (33) peut être montée diagonalement sur un angle du palpeur (5, 6) lorsque celui-ci est en forme de parallélépipède et que le couvercle (11) libère la traverse (33) dans la zone d'inclinaison correspondant approximativement à cette diagonale.

9. Interrupteur selon l'une des revendications précédentes, caractérisé en ce que le couvercle (11) est réalisé, du moins partiellement, en un matériau transparent.

10. Interrupteur selon l'une des revendications précédentes, caractérisé en ce que le couvercle (11) peut être, en outre, fixé sur la partie supérieure (3) du boîtier au moyen d'une vis (11).

11. Interrupteur selon l'une des revendications précédentes, caractérisé en ce que dans le couvercle (11) est prévue une ouverture (28) permettant l'accès au moyen d'outils jusqu'à son élément à encoches (14).
